# EUROPEAN PATENT APPLICATION

(11) **EP 4 350 936 A1**
(43) Date of publication of application: **10.04.2024**
(21) Application number: 23201316.9
(22) Date of filing: 02.10.2023
(51) Int. Cl.: H02J 7/00

(54) **A MODULAR BATTERY SYSTEM AND A METHOD OF OPERATING THEREOF**

(30) Priority: 04.10.2022 NL 2033222
(71) Applicant: Storm Group B.V., 5708 JZ Helmond (NL)
(72) Inventor: SEETSEN, Ward, Helmond (NL); VAN MEGEN, Edgar Laurens Christof Evarice, Helmond (NL)
(74) Representative: Dennemeyer & Associates S.A.

(57) **Abstract**

A modular battery system (1) and a method for providing an adjustable DC voltage output. A precharge unit (3) is provided which has a precharge contactor (5) and a precharge resistor (7), the precharge resistor being configured such that its electrical resistance is increased as its temperature increases. The precharge unit comprises an optocoupler (9) arranged to detect a voltage difference across the precharge resistor (7).

## Description

### FIELD OF THE INVENTION

The invention relates to a modular battery system for providing an adjustable direct current (DC) voltage output, wherein the system comprises a precharge unit. The invention also relates to a method of performing a preliminary mode of precharging during a power up procedure of a modular battery system. Additionally, the invention relates to an electrical system or device including at least one modular battery system.

### BACKGROUND TO THE INVENTION

Batteries are used in various applications. Modular battery systems can significantly improve design flexibility. The modular battery system may have a plurality of battery modules. The battery modules may be removably arranged, such that the number of connected battery modules may be increased or decreased for instance depending on the need or application. Furthermore, battery modules can be easily replaced where necessary.

When a battery is switched on, an output voltage is provided to a load. The output voltage of the battery jumps from zero to the generated output voltage. A resistive load may limit the electrical current. However, when the load has a capacitor, the electrical current may become too large when the battery is switched on. The battery system will supply the maximum electrical current which it can supply in order to charge the capacitor as quickly as possible. The large electrical currents can result in detrimental effects such as arc formation, and even damage one or more components of the battery system. For example, the generated arcs may cause contacts to break due to extremely high temperatures. Moreover, the massive surge in electrical current (e.g. more than 10 times, or even more than 50 times, the electrical current for which the battery system is dimensioned) can destroy or even wear out components more quickly, resulting in a reduced expected life time of the battery system. The surge can even cause damage to the load, e.g. capacitor components may blow up, resulting in a safety hazard.

It is common practice to use a precharging circuit in order to prevent such high electrical currents. Before the main contactor is closed for providing the voltage output of the battery system to the load, a precharge contactor is closed. The precharge contactor has a resistor in series for modulating the current. In this way, for instance a capacitor can be charged more slowly without causing extremely high electrical currents. When the precharging is completed, the main contactor can be closed.

However, a modular battery system can have a variable output voltage. Hence, the preconfigured resistor in the precharging circuit may be inadequate for particular output voltages which the modular battery system can deliver. For example, the precharging may take too long (cf. precharging resistor with too high resistance). In other cases, overheating may occur, which can result in hardware damage and/or safety issues (e.g. fire hazard, explosion ,etc.).

Positive temperature coefficient (PTC) thermistors are resistors with increasing resistance in function of increasing temperature. In some cases PTCs are used in the precharging circuit. For higher voltages, the PTCs heat up, and the resistance is automatically increased as desired. Pre-charge validation is performed by means of current measurements. However, current measurements are not reliable for determining a voltage difference over the precharge resistor if the resistor has a variable value, which is the case for PTCs. Moreover, isolated voltage measurements are expensive and large for higher voltages.

There is a need to improve the pre-charging solution in modular battery systems with a variable voltage output range and/or an unknown output capacitance.

### SUMMARY OF THE INVENTION

It is an object of the invention to provide for a method and a system that obviates at least one of the above mentioned drawbacks.

Additionally or alternatively, it is an object of the invention to improve the design of a modular battery system.

Additionally or alternatively, it is an object of the invention to provide for a modular battery system with improved precharging.

Additionally or alternatively, it is an object of the invention to increase the safety of operation of a modular battery system.

Thereto, the invention provides for a modular battery system for providing an adjustable direct current (DC) voltage output, wherein the system comprises a precharge unit having a precharge contactor and a precharge resistor, the precharge resistor being configured such that its electrical resistance is increased as its temperature increases, and wherein the precharge unit comprises an optocoupler arranged to detect a voltage difference across the precharge resistor.

The invention provides for an improved voltage measurement for pre-charging. The modular battery system can perform precharging with a wide output voltage range, large power requirement variation, and/or an unknown output capacitance. The system can better guarantee that precharging is performed in a safe and isolated way, even with relatively high output voltages (e.g. 1000V).

An electrical current measurement does not require a physical electrical connection as it can be measured by means of magnetic field measurements (i.e. isolated). However, since the precharge resistor is configured such that its electrical resistance is increased as its temperature increases at least in a predefined temperature range (i.e. changing resistance in function of temperature at least in a predetermined temperature range), it may not be suitable to perform electrical current measurements for identifying whether the precharging has been completed. This would be suitable for a fixed precharge resistor, but is not suitable for a variable resistance precharge resistor, which is used for the modular battery system with variable voltage output. For example, if the precharge resistor is elevated to a relatively high temperature, the electrical current is drastically reduced. However, the system may not have been pre-charged yet. The system and method according to the disclosure employs voltage measurements over the precharge resistor using an optocoupler. This provides an accurate indication about the state of precharging. Moreover, advantageously, by measuring an indication of the voltage across the precharge resistor using the optocoupler, no (external) power source (e.g. battery) is needed for performing the voltage measurements. An isolated voltage measurement typically needs a voltage supply on both sides of the isolation. An optocoupler measurement also needs a voltage supply (cf. power source), but only on the output side of the isolation, not on the input/measurement side of the isolation. A robust and cost-effective design is obtained in an advantageous way.

Optionally, the optocoupler is configured to detect whether a voltage difference threshold value has been exceeded, where a preliminary mode of precharging using the precharge unit during a power up procedure is considered successful.

The precharging has not been yet completed as long as a (threshold) voltage across the precharge resistor is detected using the optocoupler. The optocoupler can be configured to detect a voltage difference threshold where the precharge phase is considered successful. For example, when the voltage difference across the precharge resistor is smaller than the voltage difference threshold value, the preliminary mode of precharging using the precharge unit may be considered successful. This can be effectively indicated using the optocoupler. Advantageously, the precharging circuit arrangement can be implemented in a cost-effective way. Moreover, the invention provides for a simple design which can effectively work for a large output voltage range.

Optionally, the system is configured to stop precharging by suitably operating the precharge contactor based on light emitted by a light emitter of the optocoupler.

If there is a voltage across the precharge resistor, current will flow towards the optocoupler, and the light emitting diode (LED) of the optocoupler will be activated, which can be detected by a sensor.

Optionally, the system comprises a photosensor for monitoring light emitted by the optocoupler, and wherein the system is configured to halt precharging once no longer light from the light emitter of the optocoupler is detectable by the photosensor.

For example, the system has been successfully precharged and the main contactor can be closed when it is detected that the LED of the optocoupler is off by means of a photosensor. Various types of photosensitive sensors can be used.

Optionally, the optocoupler is arranged in a circuit parallel to the precharge resistor.

This provides for a simple design. Furthermore, the circuit can be integrated in a device which can be easily integrated in existing designs.

Optionally, the circuit is configured to guarantee that an electrical current through the optocoupler does not exceed a predetermined threshold value during precharging.

Optionally, the circuit comprises a first resistor (R1), a second resistor (R2) and a Zener diode arranged to limit the electrical current through the optocoupler for predefined voltage differences across the precharge resistor.

The electrical current through the optocoupler can be limited especially at higher voltage differences.

It will be appreciated that the circuit with Zener diode is not essential. It is also possible to provide equivalent arrangements or circuits (e.g. using a controlled switch) for limiting the current through the optocoupler at relatively high voltage differences.

Optionally, the circuit has a first line connected to a first node (cf. point) between the precharge contactor and the precharge resistor, and a second line connected to a second node between the precharge resistor and the output of the system, the output connectable to an electrical load, wherein the first line is connected to the first resistor (R1), the first resistor (R1) being connected to the second resistor (R2), the second resistor (R2) being connected to an anode of the optocoupler, and wherein the second line is connected to a cathode of the optocoupler, and wherein the Zener diode is arranged in a line connecting the second line to an intermediate node between the first resistor (R1) and the second resistor (R2), and wherein a cathode of the Zener diode is connected to the intermediate node.

The first resistor (R1), second resistor (R2) and the Zener diode in the circuit are configured to ensure that the voltage across the optocoupler and electrical current through the optocoupler does not exceed a predetermined maximum value. In this way, damage to the optocoupler can be prevented. The safety of the modular battery system can be improved.

The voltage difference across the precharge resistor generates a current across R1 and R2 which is detected by means of the optocoupler.

Optionally, the system comprises an auxiliary circuit having a same configuration as the circuit, wherein an auxiliary first line of the auxiliary circuit is connected to the second point node between the precharge resistor and the output of the system, and wherein an auxiliary second line of the auxiliary circuit is connected to the first point node between the precharge contactor and the precharge resistor.

Advantageously, the auxiliary circuit can be used for measuring voltage in one direction and if the output has a higher voltage than the input (for example with several battery packs on the same bus), this can be effectively detected before the main contactor is closed.

Optionally, the auxiliary circuit includes an auxiliary first line connected to the second point node, and an auxiliary second line connected to the first point node, wherein the auxiliary first line is connected to an auxiliary first resistor (R1), the auxiliary first resistor (R1) being connected to an auxiliary second resistor (R2), the auxiliary second resistor (R2) being connected to the an anode of an auxiliary optocoupler, and wherein the auxiliary second line is connected to the a cathode of the auxiliary optocoupler, and wherein an auxiliary Zener diode is arranged in a line connecting the auxiliary second line to an intermediate point node between the auxiliary first resistor (R1) and the auxiliary second resistor (R2), and wherein a cathode of the auxiliary Zener diode is connected to the intermediate point node.

Optionally, the modular battery system includes a main contactor switchable between a closed state, in which the energy storage unit is electrically connected to an output, and an open state, in which the electrical connection between the energy storage unit and the output is interrupted by said contactor, wherein during precharging the main contactor is in an open state, and wherein the main contactor is switched to a closed state and the precharge contactor is opened in order to halt the preliminary mode of precharging based on light emitted by the optocoupler.

The main contactor may be switched based on detected light emitted by the optocoupler of the circuit and/or that of the auxiliary circuit.

Optionally, the precharge resistor is a positive temperature coefficient (PTC) resistor.

Optionally, the modular battery system has a concatenation of a number of battery modules, each battery module including at least one rechargeable battery cell, wherein the number of battery modules in the modular battery system and/or arrangement of said battery modules in the modular battery system are adaptable.

Optionally, the modular battery system has an adjustable voltage output within a predefined voltage range.

Optionally, the predefined voltage range of the modular battery system is 50 to 2000 Volt, more preferably 120 to 1000 Volt.

According to an aspect, the invention provides for a method of performing a preliminary mode of precharging during a power up procedure of a modular battery system, the modular battery system configured to provide an adjustable direct current (DC) voltage output, wherein the method includes providing a precharge unit including a precharge contactor and a precharge resistor, the precharge resistor being configured such that its electrical resistance is increased as its temperature increases, and providing the precharge unit with an optocoupler for detecting a voltage difference across the precharge resistor.

The method provides for an improved precharging for a modular battery system with a carriable voltage output. The variable voltage output of the modular battery system may make it desirable to use a PTC precharger resistor, as the resistance of the resistor dynamically changes in function of the temperature. Advantageously, an indication of the voltage across the precharge resistor is detected using an optocoupler.

According to an aspect, the invention provides for a circuit for detecting a voltage across a precharge resistor of a modular battery system, wherein the circuit comprises a first line, and a second line, wherein the first line is connected to a first resistor (R,1), the first resistor (R1) being connected to a second resistor (R2), the second resistor (R2) being connected to an anode of an optocoupler, and wherein the second line is connected to a cathode of the optocoupler, and wherein a Zener diode is arranged in a line connecting the second line to an intermediate node between the first resistor (R1) and the second resistor (R2), and wherein a cathode of the Zener diode is connected to the intermediate node.

Optionally, the first line of the circuit is connected to a first node between the precharge contactor and the precharge resistor, and the second line of the circuit is connected to a second node between the precharge resistor and the output of the system.

Additionally or alternatively, the first line of the circuit is connected to the second node between the precharge resistor and the output of the system, and the second line of the circuit is connected to the first node between the precharge contactor and the precharge resistor.

Optionally, the output is connectable to an electrical load.

According to an aspect, the invention provides for an electrical system or device including at least one modular battery system according to the disclosure.

It will be appreciated that any of the aspects, features and options described in view of the modular battery system apply equally to the method and the described electrical device and use. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
Fig. 1 shows a schematic diagram of an embodiment of a system;
Fig. 2 shows a schematic diagram of an embodiment of a system; and
Fig. 3 shows a schematic diagram of an embodiment of a system.

### DETAILED DESCRIPTION

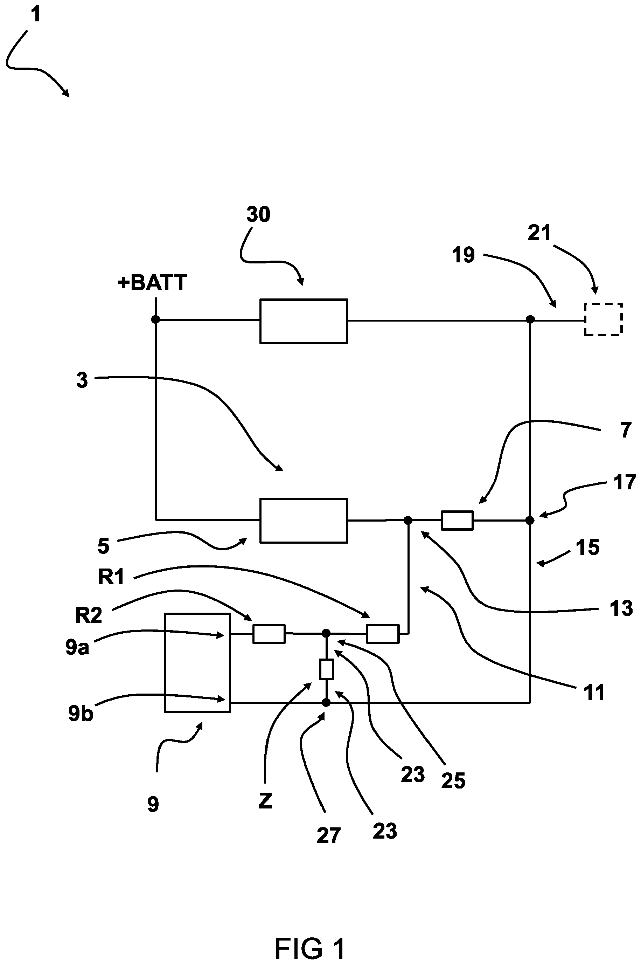

Fig. 1 shows a schematic diagram of an embodiment of a modular battery system 1 for providing an adjustable direct current (DC) voltage output. The modular battery system 1 comprises a precharge unit 3 having a precharge contactor 5 and a precharge resistor 7. The precharge resistor 7 is configured such that its electrical resistance is increased as its temperature increases. The precharge unit 3 comprises an optocoupler 9 arranged to detect a voltage difference across the precharge resistor 7. Based on light emitted by the LED of the optocoupler it can be determined whether the system has been successfully precharged.

In this example, the optocoupler 9 is arranged to detect a voltage difference threshold where a preliminary mode of precharging using the precharge unit 3 during a power up procedure is considered completed/successful. The modular battery system 1 may for example be configured to stop precharging by suitably operating the precharge contactor 5 based on detected light emitted by a light emitter of the optocoupler 9. For example, the modular battery system 1 may be provided by at least one photosensor for monitoring light emitted by the optocoupler 9, wherein the system is configured to stop/halt precharging once no longer light from the light emitter of the optocoupler 9 is detectable by the photosensor.

In this example, the optocoupler 9 is arranged in a circuit parallel to the precharge resistor 7. The circuit is configured to guarantee that an electrical current through the optocoupler 9 does not exceed a predetermined threshold value during precharging. In this way, damage to the optocoupler can be prevented. The circuit comprises a first resistor (R1), a second resistor (R2) and a Zener diode (Z) arranged to limit the electrical current through the optocoupler 9 for predefined voltage differences across the precharge resistor 7. In some examples, the circuit comprises a first line 11 connected to a first node 13 between the precharge contactor 5 and the precharge resistor 7, and a second line 15 connected to a second node 17 between the precharge resistor 7 and the output 19 of the modular battery system 1. The output 19 is connectable to an electrical load 21. The first line 11 is connected to the first resistor R1, the first resistor R1 being connected to the second resistor R2, the second resistor R2 being connected to an anode 9a of the optocoupler 9, and wherein the second line 15 is connected to a cathode 9b of the optocoupler 9. The Zener diode Z is arranged in a line 23 connecting the second line 15 to an intermediate node 25 between the first resistor R1 and the second resistor R2. A cathode of the Zener diode Z is connected to the intermediate node 25. Said line 23 is connected to the second line 15 via node 27.

Furthermore, in this example, the modular battery system 1 includes a main contactor 30 switchable between a closed state, in which an energy storage unit (cf. +BATT in figure) of the modular battery system 1 is electrically connected to an output, and an open state, in which the electrical connection between the energy storage unit and the output 19 is interrupted by said main contactor 30. During precharging the main contactor 30 is in an open state, and wherein the main contactor 30 is switched to a closed state and the precharge contactor 5 is opened in order to halt the preliminary mode of precharging based on light emitted by the optocoupler 9.

In some examples, the modular battery system 1 comprises an energy storage unit comprising at least one battery module having one or more rechargeable battery cells, wherein the modular battery system is configured to provide an adjustable DC voltage output.

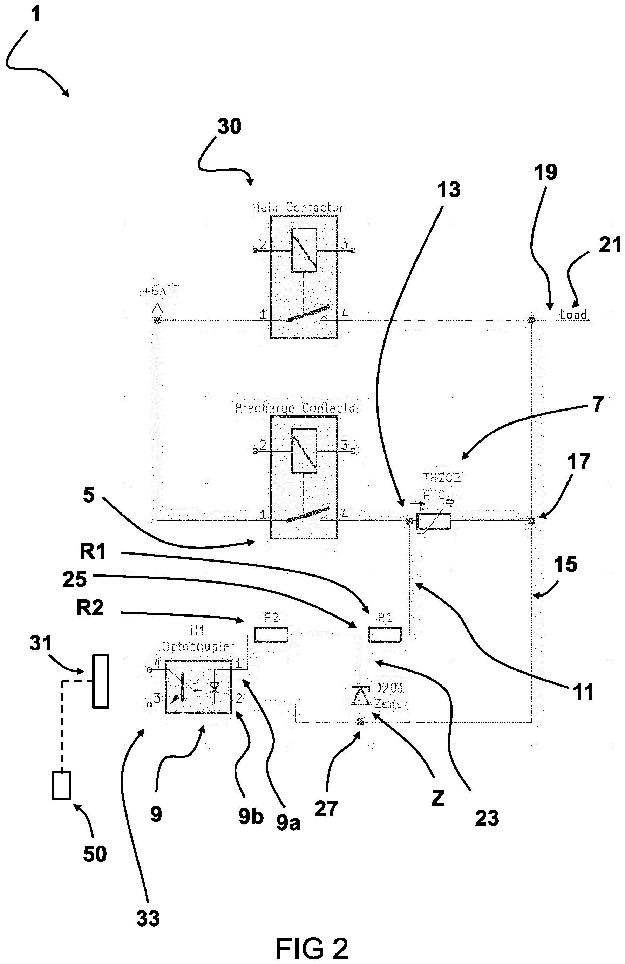

Fig. 2 shows a schematic diagram of an embodiment of a modular battery system 1. The precharge resistor 7 is a positive temperature coefficient (PTC) resistor.

The system comprises an optocoupler 9 with a photosensor integrated therein to detect light emitted by its LED. However, alternatively, it is also possible to employ an external photosensor. An exemplary external photosensor 31 for monitoring light emitted by the optocoupler 9 (cf. via LED of optocoupler 9) is illustrated. A controller 50 may be configured to receive sensory data of the photosensor 31 (integrated or external sensor). The controller 50 may be configured to stop, halt or interrupt the precharging once no longer light from the light emitter 33 of the optocoupler 9 is detectable by the photosensor 31.

The controller 50 may thus determine based on the light detected by the photosensor 31 whether precharging has been completed and/or successful. The controller can then close the main contactor 30 and open the precharge contactor 5. As a result, the +BATT is directly connected to the output 19.

A controller (e.g. microcontroller) may be linked/coupled to the photosensor (or transceiver thereof) such as to suitably operate the main contactor and the precharge contactor of the battery system. For example, when it is detected using light emitted by the LED of the optocoupler that precharging has been completed, the precharge contactor can be opened and the main contactor closed.

The resistance of the PTC precharge resistor 7 increases as it heats up. Hence, for smaller output voltages during precharging, the PTC can have smaller resistances. For higher output voltages during precharging, the PTC can have higher resistances due to the temperature increase. The resistance of the PTC can thus be automatically adjusted without an active control mechanism (cf. self-leveling).

The optocoupler 9 provides a simple and effective way to communicate the presence of a voltage across the precharge resistor 7 in an isolated manner. The light emitted by the LED of the optocoupler 9 may easily detected by means of the photosensor. The photosensor may for example be integrated in the optocoupler 9. Various types of photosensitive sensors can be employed.

The optocoupler 9 can have a certain range of electrical current in which it is activated. In some examples, the optocoupler 9 may be configured such that its LED is turned on when the voltage across the precharge resistor is larger than an upper threshold voltage value (e.g. 1000V), and such that its LED is turned off when the voltage across the precharge resistor is smaller than a predetermined lower threshold voltage value (e.g. 15V). Initially, the electrical current flows through R1 and then through the Zener diode and then back. When precharging is almost completed, the electrical current will flow through R1 and R2 and the optocoupler 9.

The Zener diode may be configured to conduct when the voltage between its two pins is above a predetermined level. This predetermined voltage level at which the Zener diode starts to conduct may for instance be 36 V. Therefore, if the voltage is larger than or equal to e.g. 36 V, then the Zener diode will conduct electrical current. The LED of the optocoupler 9 is thus not activated in this case. If the voltage is smaller than 36 V, the electrical current will not pass through the Zener diode and the electrical current will flow through the optocoupler and the LED of the optocoupler will be activated.

The optocoupler 9 provides an effective indication of whether the precharging has been carried out (cf. completed successfully). However, if the precharging is not successful within a predetermined period of time, the precharging may be stopped. The controller of the battery system may perform the necessary actions to stop the precharging.

The modular battery system 1 can have a concatenation of a number of battery modules, each battery module including at least one rechargeable battery cell (typically multiple cells), wherein the number of battery modules in the modular battery system and/or arrangement of said battery modules in the modular battery system are adaptable. As a result, the output voltage of the modular battery system 1 can be variable. In some examples, the modular battery system has an adjustable voltage output within a predefined voltage range.

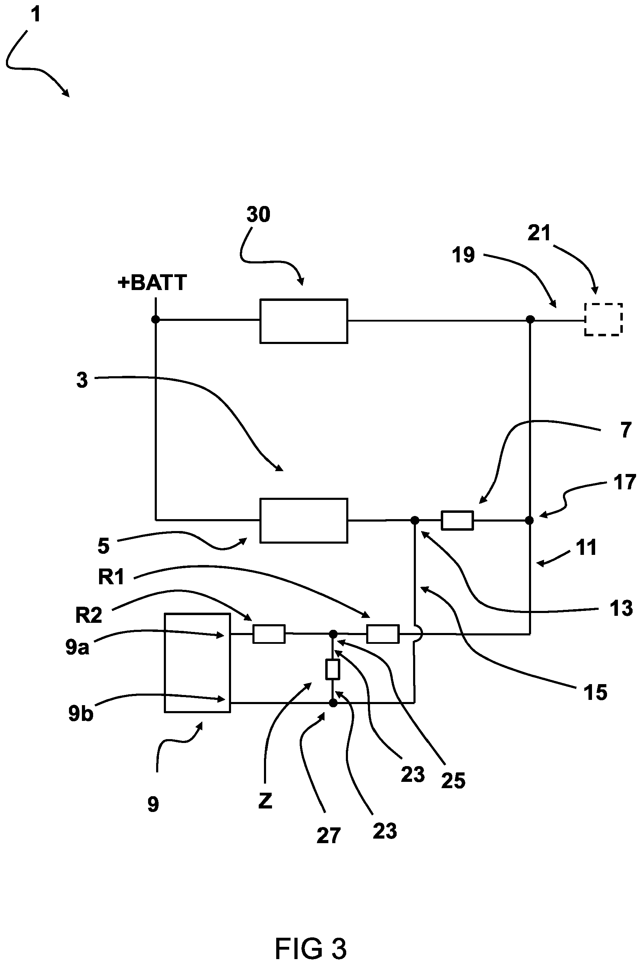

Fig. 3 shows a schematic diagram of an embodiment of a system 1. In this example, an auxiliary circuit is shown. The auxiliary circuit has a similar/same configuration as the circuit shown in figs. 1 and 2. However, the circuit is connected differently. More particularly, the first line 13 of the auxiliary circuit is connected to the second point node 17 between the precharge resistor 7 and the output 19 of the system 1. A second line 15 of the auxiliary circuit is connected to the first point node 13 between the precharge contactor 5 and the precharge resistor 7.

The auxiliary circuit can be used for measuring voltage in one direction and if the output has a higher voltage than the input, this can be effectively detected before the main contactor is closed. This may for instance occur if several battery packs are provided on the same bus.

It will be appreciated that the method may include computer implemented steps. All above mentioned steps can be computer implemented steps. Embodiments may comprise computer apparatus, wherein processes performed in computer apparatus. The invention also extends to computer programs, particularly computer programs on or in a carrier, adapted for putting the invention into practice. The program may be in the form of source or object code or in any other form suitable for use in the implementation of the processes according to the invention. The carrier may be any entity or device capable of carrying the program. For example, the carrier may comprise a storage medium, such as a ROM, for example a semiconductor ROM or hard disk. Further, the carrier may be a transmissible carrier such as an electrical or optical signal which may be conveyed via electrical or optical cable or by radio or other means, e.g. via the internet or cloud.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A modular battery system for providing an adjustable direct current (DC) voltage output, wherein the system comprises a precharge unit having a precharge contactor and a precharge resistor, the precharge resistor being configured such that its electrical resistance is increased as its temperature increases, and wherein the precharge unit comprises an optocoupler arranged to detect a voltage difference across the precharge resistor.

2. The modular battery system of claim 1, wherein the optocoupler is configured to detect whether a voltage difference threshold value has been exceeded where a preliminary mode of precharging using the precharge unit during a power up procedure is considered successful.

3. The modular battery system of claim 1 or 2, wherein the system is configured to stop precharging by suitably operating the precharge contactor based on light emitted by a light emitter of the optocoupler.

4. The modular battery system of claim 3, wherein the system comprises a photosensor for monitoring light emitted by the optocoupler, and wherein the system is configured to halt precharging once no longer light from the light emitter of the optocoupler is detectable by the photosensor.

5. The modular battery system according to any one of the preceding claims, wherein the optocoupler is arranged in a circuit parallel to the precharge resistor.

6. The modular battery system according to claim 5, wherein the circuit is configured to guarantee that an electrical current through the optocoupler does not exceed a predetermined threshold value during precharging.

7. The modular battery system according to claim 5 or 6, wherein the circuit comprises a first resistor (R1), a second resistor (R2) and a Zener diode arranged to limit the electrical current through the optocoupler for predefined voltage differences across the precharge resistor.

8. The modular battery system according to claim 7, wherein the circuit has a first line connected to a first node between the precharge contactor and the precharge resistor, and a second line connected to a second node between the precharge resistor and the output of the system, the output connectable to an electrical load, wherein the first line is connected to the first resistor (R1), the first resistor (R1) being connected to the second resistor (R2), the second resistor (R2) being connected to an anode of the optocoupler, and wherein the second line is connected to a cathode of the optocoupler, and wherein the Zener diode is arranged in a line connecting the second line to an intermediate node between the first resistor (R1) and the second resistor (R2), and wherein a cathode of the Zener diode is connected to the intermediate node.

9. The modular battery system according to claim 8, wherein the system comprises an auxiliary circuit having a same configuration as the circuit, wherein an auxiliary first line of the auxiliary circuit is connected to the second point node between the precharge resistor and the output of the system, and wherein an auxiliary second line of the auxiliary circuit is connected to the first point node between the precharge contactor and the precharge resistor.

10. The modular battery system according to any one of the preceding claims 3-8, wherein the modular battery system includes a main contactor switchable between a closed state, in which an energy storage unit of the modular battery system is electrically connected to an output, and an open state, in which the electrical connection between the energy storage unit and the output is interrupted by said contactor, wherein during precharging the main contactor is in an open state, and wherein the main contactor is switched to a closed state and the precharge contactor is opened in order to halt the preliminary mode of precharging based on light emitted by the optocoupler.

11. The modular battery system according to any one of the preceding claims, wherein the precharge resistor is a positive temperature coefficient (PTC) resistor.

12. The modular battery system according to any one of the preceding claims, wherein the modular battery system has a concatenation of a number of battery modules, each battery module including at least one rechargeable battery cell, wherein the number of battery modules in the modular battery system and/or arrangement of said battery modules in the modular battery system are adaptable.

13. A method of performing a preliminary mode of precharging during a power up procedure of a modular battery system, the modular battery system configured to provide an adjustable direct current (DC) voltage output, wherein the method includes providing a precharge unit including a precharge contactor and a precharge resistor, the precharge resistor being configured such that its electrical resistance is increased as its temperature increases, and providing the precharge unit with an optocoupler for detecting a voltage difference across the precharge resistor.

14. An electrical system or device including at least one modular battery system according to any one of the preceding claims 1-12.
